**Europäisches Patentamt**

**European Patent Office**

**Office européen des brevets**

(11) Publication number : **0 513 967 A2**

(12) # EUROPEAN PATENT APPLICATION

(21) Application number : **92301579.6**

(22) Date of filing : **25.02.92**

(51) Int. Cl.⁵ : **H01L 21/00**

(30) Priority : **28.02.91 US 662016**

(43) Date of publication of application :
**19.11.92 Bulletin 92/47**

(84) Designated Contracting States :
**DE FR IT**

(71) Applicant : **SUBMICRON SYSTEMS, INC.**
**400 Hedgewood Drive, Suite 150**
**Llentown, PA 18106 (US)**

(72) Inventor : **Molinaro, James S.**
**826 Catherine Drive**
**Coplay, PA 18037 (US)**

(74) Representative : **Parr, Ronald Edward R.E. Parr**
**& Co.**
**Colman House Station Road**
**Knowle Solihull West Midlands B93 0HL (GB)**

(54) **Automated wet chemical processing system.**

(57)   An automated wet process station which provides for simultaneous batch processing of multiple wafer carriers without operator interaction through a unique robotic system transfer which processes the product from the rear of the automated wet processing station. A computer monitors and controls all aspects of the wet station and the automated robotic station. The following component support equipment are provided including a wet process station with process tanks, input staging area, output staging area, robot transfer arm, and a control zone. Other components and support equipment include a braker panel, recirculation/filteration cabinet, a chemical mixing/recirculation/filteration cabinet, circulator/heat exchange unit, a capacitance level sensor controller, a vapor dryer unit, an ozone generator, an ozone filter box, and a fire control system, some of which are optional components.

FIG. 1

EP 0 513 967 A2

The present invention relates to apparatus for use in treatment or processing of components or other articles. In particular, though not exclusively, it relates to apparatus for processing semiconductor wafers at one or more stations, especially using an automated wet chemical process. In a preferred form the apparatus includes a cantilevered robotic arm.

The manufacture of silicon semiconductor wafers for integrated circuiuts must be done in a highly controlled, clean environment. Any particulate matter in the air must be minimized.

A typical wet station for processing semiconductor wafers uses a series of liquids which must also be carefully controlled. Care must also be taken to control fumes given off by the liquid or liquids.

These requirements have led to the practice of treating semiconductor wafers in a contaminant-free environment known as a "clean room".

The evolution of clean room structure has lead to the separation of various activities so that mechanical parts, which would be deleterious to clean room conditions, have been moved into adjacent service modules. A wall or other partition, for example a non-structural wall, divides the maintenance, or mechanical area (referred to herein also as the "chase area" or "chase zone") from the clean room environment (referred to herein also as the "clean area" or "clean zone"). In this manner, personnel without clean room apparel can service the equipment as may be necessary. Additionally, the moving parts in the chase zone do not contribute to clean room contamination.

However, the prior art apparatus has not been very satisfactory. According to the present invention we have realised that there is a need for an automated apparatus that would permit:

(a) mechanical parts and controls to be situated to the rear or non-clean room (chase) side of the wet station; and/or

(b) a means of moving wafer carriers using apparatus that operates from the rear, or non-clean room side, of the wet station.

The present invention provides such apparatus.

Accordingly, in a first aspect the present invention provides apparatus for use in treatment of an article, characterised in that the apparatus comprises:

a plurality of treatment tanks (14) in which the article is to be treated;

a mechanism (30) to convey said article to the interior of the tanks in succession, the mechanism including a cantilever arm (34) having at its distal end means to hold said article and whose proximal end is operatively connected to advance means to advance the mechanism with respect to the tanks, said advance means being distant from the tanks, thereby to preclude contaminating particles from the advance means coming into contact with said article; and

an electronic control means to control said mechanism in accordance with a pre-determined programme.

The treatment tank or tanks of apparatus of the invention are also referred to as the "wet station" or "wet processing station". Where more than one treatment tank is used the tanks are conveniently arranged in a row, for example a straight row, to facilitate movement of the article or product to and from individual tanks or from on tank to another.

In a second aspect the present invention provides an assembly which comprises:

(a) apparatus according to said first aspect of the invention; and

(b) a wall, screen, window or other partition to separate from each other a clean zone portion of the apparatus from a chase zone portion of the apparatus.

In a preferred form of the assembly the clean zone contains the treatment tanks and the chase zone contains mechanical components which can give rise to contaminating dust or particles.

Apparatus (also referred to herein as "system") according to preferred forms of the present invention includes an input staging area, multiple wet process tanks, an output staging area, a control system, and a robotic arm for moving wafers through the wet station. The wet station preferably includes plastic, transparent front panels which allow viewing of the processing in the tanks while controlling fume exhaust.

The system includes, for example, a cantilevered robot system including a horizontal track extending along the rear side of the wet processing station, a robot mechanism mounted for moving along the track, a vertically height-adjustable robot standard, a cantilevered horizontally-extending arm attached to the standard extending out over the wet process tanks, and a robot end effector for engaging, for example, wafer carriers or baskets. The cantilevered robot arm moves product from the input staging area, to successive process tanks and onto the output staging area without exposing the clean room environment to the moving parts which can lead to contamination.

In a further aspect the invention provides a robot for moving product through successive processing baths, comprising:

a. a vertical height-adjustable robot standard (32);

b. a horizontal arm (34) extending outward from generally the top of the robot standard;

c. a vertically descending robot arm (36) for engaging product to be processed; and

d. robot control means including means for moving the robot horizontally behind successive process tanks.

There is now described, by way of example and with reference to the accompanying drawings, preferred embodiments of the apparatus and robot of the first and second aspects, respectively, of the present invention.

In the drawings:

FIG. 1 is a perspective view of an automatic wet chemical process apparatus of the first aspect of the invention;

FIG. 2 is a cross-sectional view of a first embodiment of the chemical process apparatus of the invention;

FIG. 3 is a cross-sectional view of an alternative embodiment of chemical process apparatus of the invention; and

FIG. 4 is a cross-sectional view of the robot of the invention.

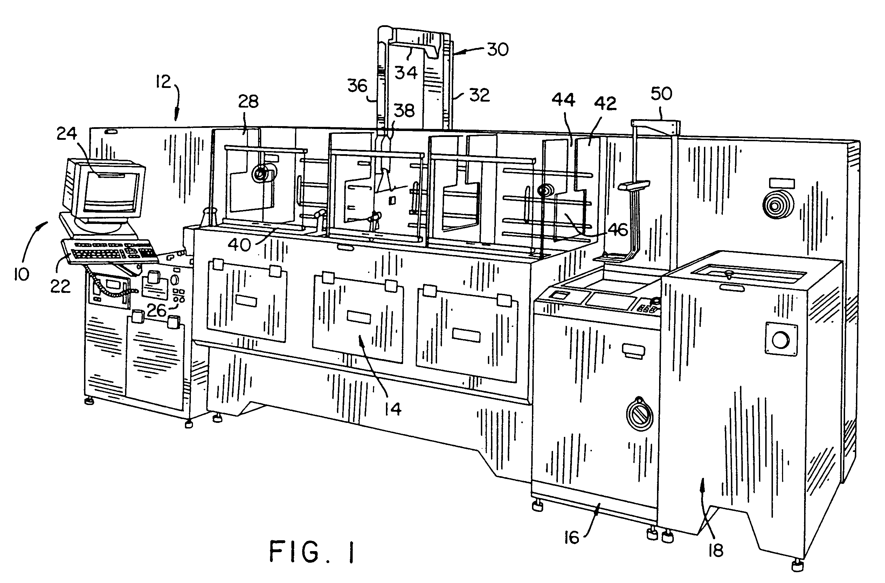

FIG. 1 illustrates a perspective view of an automated chemical process apparatus constructed according to the present invention, and provides a completely integrated processing control system. As is shown below, the system includes wafer handling equipment, processing tanks, a dryer, control station and remote SCS computer interface capabilities.

The system components include a control module 10, loading module (12), process tank (14), a dryer (16), and an unloading module (18).

The system can be configured by those skilled in the art to create a proper sequence for particular application processing requirements. The process baths or tanks (14) are preferably modular, each module being equipped, for example, with independent control input/ output capabilities along with heating, water and chemical dispensing, level metering, and replenishment capabilities appropriate to the particular function. Typical modules of process tanks (14) are set out below under numbers 1 to 6. These tanks (referred to also as "baths" herein) can be, for example, respectively, the tanks shown in Figure 1 reading from left to right. The contents of the tanks can be as set out below but these contents are given by way of example and for purposes of illustration only and not to be construed as limiting the present invention.

1. For pre-diffusion cleaning, the following baths are commonly used:

    A. $H_2SO_4/H_2O_2$ Bath

    B. Hot Cascade Rinse

    C. $DI/NH_4OH/H_2O_2$ Bath

    D Ambient Cascade Rinse

    E. DI/HF Bath

    F. Ambient Cascade Rinse

    G. $DI/HCL/H_2O_2$ Bath

    H. Ambient Cascade Rinse

    I. Ambient Cascade Rinse.

2. For pre-EPI cleaning, the following sequence is preferred:

    A. DI/HF Bath

    B. Ambient Cascade Rinse

    D. $DI/NH_4OH/H_2O_2$ Bath

    E. Ambient Cascade Rinse

    F. Ambient Cascade Rinse

3. For $Si_3N_4$ stripping, the following sequence is preferred:

    A. $H_3PO_4$ Bath

    B. $H_3PO_4$ Bath

    C. Quick DUmp Rinse

    D. Ambient Cascade Rinse

4. For photo-resist stripping, the following sequence is preferred:

    A. $H_2SO_4$ Bath

    B. $H_2SO_4$ Bath

    C. Hot Cascade Rinse

    D. Ambient Cascade Rinse

5. For etching of ionized silicon film, or BOE, the following sequence is preferred:

    A. BOE Bath

    B. Quick Dump Rinse

    C. Ambient Cascade Rinse

6. For HF cleaning, the following sequence is preferred:

    A. HF Process Tank

    B. Quick Dump Rinse

    C. Ambient Cascade Rinse

Those skilled in the art may apply the teachings of these sample sequences to establish appropriate modular tanks for particular applications. Each of the sequences is preferably followed by dryer 16. Dryer 16 may be a spin dryer or an IPA (isopropyl alcohol) vapor dryer as selected by those skilled in the art. Any other type of dryer could also be utilized.

Control module 10 is based around a computer, not illustrated, such as a Stargate System having a microprocessor-based computer board or mode connection panel. The typical computer chosen has, for example, eight serial ports so that each serial cable can be handled separately to allow for different baud rates and etching protocols. The computer is responsible for buffering all of the outgoing and incoming serial data. The computer is responsible for all timing and serial communication protocols. One skilled in the art may select various computer systems which can be appropriately programmed to use a menu-driven protocol for controlling the chemical processing system. Preferably, the computer is controlled by keyboard 22 and monitor (24). Other manually operated controls (26) are mounted on loading module (12).

The apparatus, assembly and robot of the invention are suited, by way of example, to the treatment of semiconductor wafers or semiconductor substrates, and it is with particular reference to such products that the following description particularly relates. For example, multiple wafers are mounted in a basket or rack, and then loaded by the operator into input staging area (28) of loading module (12). Upon loading, the computer prompts the operator on a monitor (24) for a lot tracking code for the product. This lot tracking code is used to identify the product as it moves through the system. Once this information is entered on keyboard (22), the computer checks that the process tanks (14) are at the proper processing temperatures according to the process algorithm for the particular product.

When the system is ready, the computer adds the product to a pickup schedule stored in memory. The system intrudes a robot (30) which moves product horizontally through the system. Robot (30) includes a vertical standard (32) horizontal arm (34), and a vertically descending arm (36) having a hand or gripper (38) at its lower end. Robot (30) is mounted for horizontal movement (from left to right as viewed in FIG. 1) along the system behind process tanks (14). Vertical standard (32) is height-adjustable for moving hand (38) up and down. The horizontal arm (34) is cantilevered out over process tanks 14 so that the hand 38 can operate in all various process tanks 14.

With this cantilevered arrangement all of the moving parts controlling robot arm (30) are at the rear of the apparatus and much less likely to provide any contaminants in operation of the chemical process. The computer is electrically linked to controls for the robot 30 so that its movement can be controlled

When the product tracking code has been entered, robot 30 is signaled to pick-up product from the input staging area 28 according to a schedule stored in the computer. The robot 30 then transfers the product to the proper transfer tank 14.

An algorithm is stored in the computer for the chosen process, including proper fluids, temperatures, and the time that product spends in each tank 14. The computer tracks the time that each semiconductor wafer in the wafer carrier remains in each process tank 14. When the time is expired, the robot 30 moves the semiconductor wafer to the next tank 14 according to the algorithm. This process continues until the requirements of the algorithm are complete. The semiconductor wafer is transported to the output staging area. Once in the output staging area, the operator removes the semiconductor wafer.

Using the schedule, the computer can run more than one wafer carrier through the system at one time. The computer ensures that each wafer carrier is moved from each critical tank on time. The computer will not bring a new wafer carrier into the system if it would endanger the processing of another wafer carrier already in station. For example, for a new wafer carrier to enter the system, there must be time available in each of the tanks to properly handle the wafer carrier without exceeding the maximum processing time. If there is in the system a wafer carrier that would block a new wafer carrier along the way, the new wafer carrier will not be entered until there is a planned path available in the system according to the algorithm.

Process tanks 14 are equipped with translucent or other front panels 40, for example of Lucite plastic or similar polymer. The front panels 40 prevent migration of fumes from the system and protect the process tanks 14 from contaminants. Lucite divider panels 42 separate the areas above tanks 14. An arm aperture 44 and a longer basket aperture 46 allow robot 30 to move a wafer carrier between successive process tanks 14.

The dryer 16 is equipped with its own robot 50 for lowering the product into dryer 16.

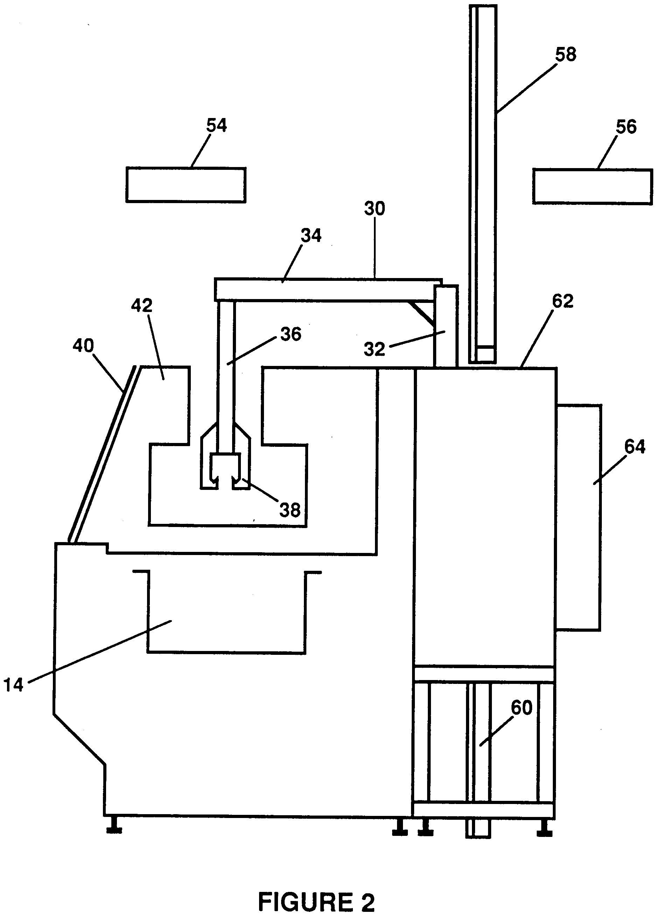

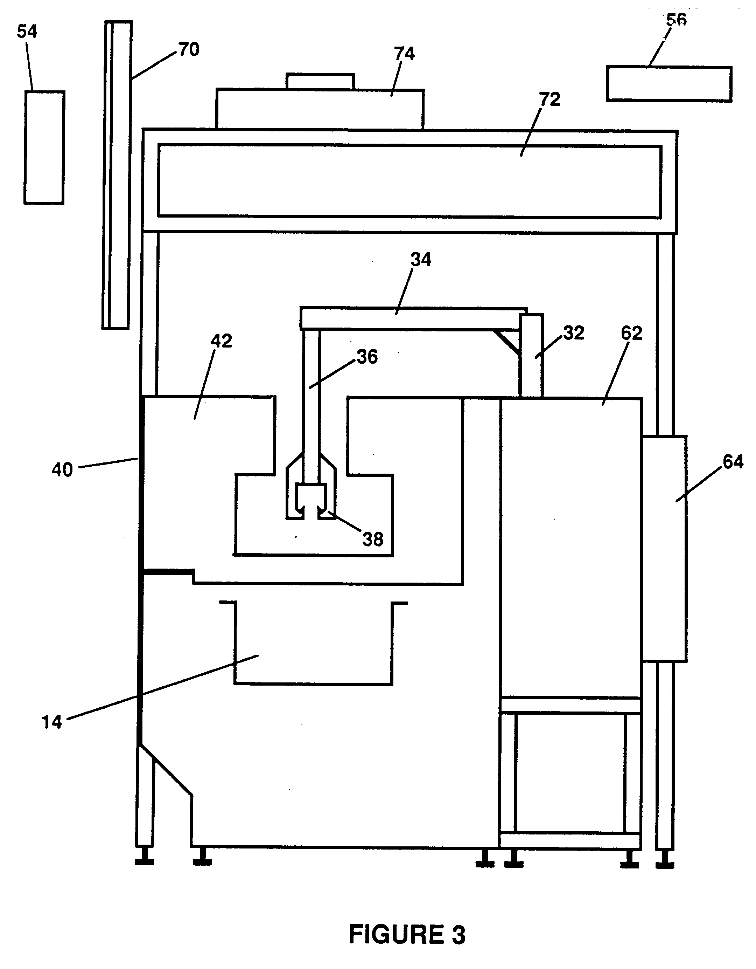

The flexibility of the system of the invention is illustrated by FIGS. 2 and 3 which show alternative installation modes for the system.

FIG. 2 illustrates a cross-sectional view of the system mounted between a clean room area (54) and a chase or maintenance area (56). Rooms (54) and (56) are separated by a partition in the form of a wall consisting of wall panels (58) and (60). Standard industry panels, such as those sold under the Trade Mark "UniStrut" may be used. Robot (30) moves to successive process tanks (14) within the clean room. All mechanical parts for the robot (30) are in housing (62) at the rear of the system which extends into the chase area. Mounted on housing (62) is the control and breaker zone (64). Thus, all the maintenance parts of the system are accessible from the chase area (56). As is known in the art, it is easiest to control particulate levels in the clean room (54) if the size of that room and the number of operations which go on in it are minimized: all maintenance operations are best effected in chase area (56). Using robot 30, all robot controls (62) are chase-mounted and accessible from the chase area (56).

FIG. 3 illustrates an alternative embodiment in which a UniStrut panel (70), separating the clean room and chase areas, is mounted against the front of the system. In this embodiment, a laminar flow module (72) is mounted on the top of the system. The system also employs a HEPA module (74) which is clean to 99.999%. In this embodiment, front panels (40) seal off all chemical processes from clean room (54). The entire system is mounted in chase area (56), further reducing particulate risks.

Dimensions, given by way of example, of the embodiments of FIGS. 2 and 3 include a front to rear tank dimension A of 965mm (38 inches), robot control front to rear mesurement of B of 483mm (19 inches) and vertical robot height C of 1702mm (67 inches). IN FIG. 3, dimension D is preferably 1981mm (78 inches). These dimensions are illustrative. Those skilled in the art may adopt the system to other dimensions for particular applications. In the particular illustrated embodiment process tank (14) is 483mm (19-inch) inner-molded quartz tank using a high-purity base material of less metal contamination than other materials commonly used.

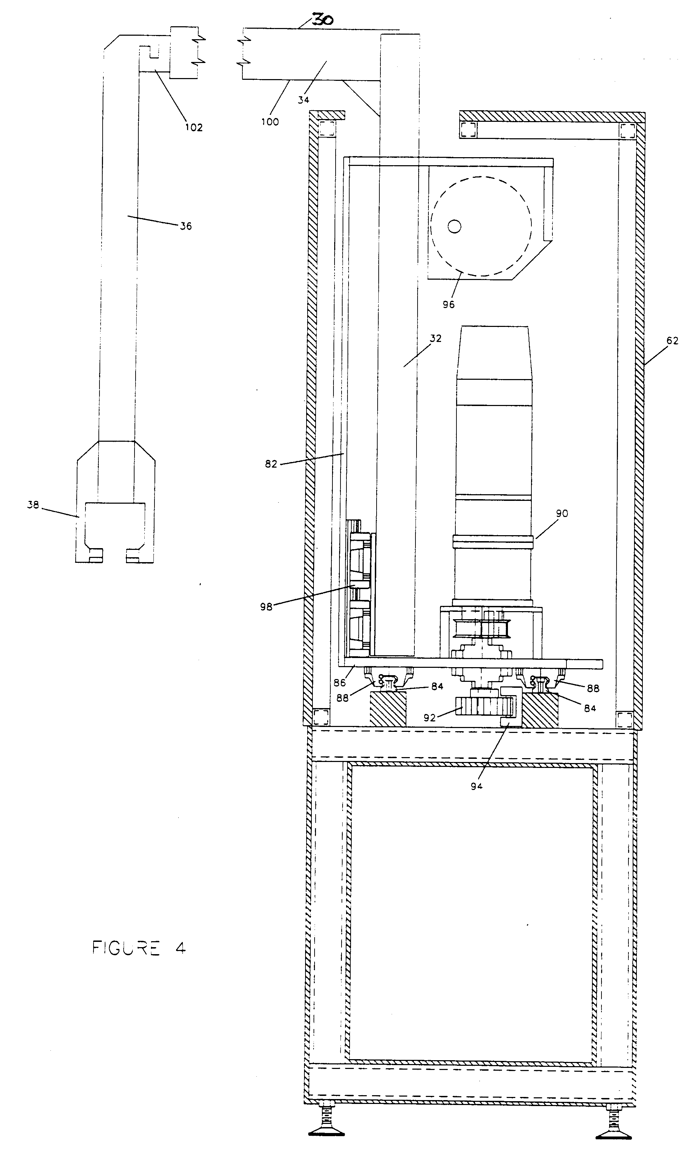

FIG. 4 illustrates the structure of robot (30) which includes robot torso (82). A pair of rails (84) are mounted longitudinally along the system within connector housing (62). Torso (82) has a frame (86) having two guides (88), and includes a motor (90) which provides rotational energy to pinion (92). As pinion (92) rotates, its teeth "walk" along rack (94) which is longitudinally mounted in cabinet (62) parallel to rails (84). Rack (94) is preferably made of cylindrical vertical bars, rather than teeth, since the cylindrical bars are less likely to provide metal contaminants to the system. In operation, as pinion (92) rotates, it engages rack (94) and moves longitudinally along the system carrying robot torso (82) along the path past various process tanks (14). The torso also includes motor (96) to move standard (32) vertically along the slidable attachment to mount (98). Horizontal arm (34) includes first segment (100) and second segment (102) which can be extended to adjust the horizontal length of horizontal arm (34).

The apparatus and robot of the invention can be used as follows.

The operator places product on the input staging area. The computer will then prompt the operator for a lot tracking code which will be used to identify the product as it moves through the system. Once this information is entered, the computer will check that the process tanks are at the proper temperatures, according to the process recipe for this product. When the system is ready, the computer will add this product to its pick-up schedule. The robot transfer arm will pickup the product from the input staging area according to schedule and transfer it to the proper process tank. The computer will keep track of the time that the product remains in the process tank. When the time has expired, the transfer arm will move the product to the next tank according to the recipe. This process will continue until the requirements of the recipe are complete and the product is transported to the output staging area. The operator should remove the product from the output staging area promptly. If the output staging area is full, the system will sit idle waiting for these positions to be cleared. The computer can run more than one product through the system at one time if it is possible. The computer always makes sure that product is removed from critical tanks on time. For this reason, new product cannot be brought into the system if it would endanger the processing of another product already in the station.

In the structure of the system constructed according to the present invention, all of the moving parts, such as motor (90), rack (94), and pinion (92), are mounted in the robot housing (62), away from chemical tank area where metallic particulate generated by friction could interfere with proper chemical processing.

The present invention provides solutions to the major failings of the prior art because horizontal arm (34) extends over the tanks (14). The present invention maximizes the equipment in the chase area (56), and minimizes contaminant producing equipment in the clean room (54). Moving parts which could produce particulate contamination due to frictional mechanical wear are located in the chase area (56).

With further reference to the embodiment described above with reference to Figure 3, although the apparatus is located in a chase area, it is sealed or otherwise enclosed therefrom and thus operates under clean room conditions.

## Claims

1. Apparatus for use in treatment of an article with a fluid in a clean zone,
   characterised in that the apparatus comprises:
   a plurality of treatment tanks (14) in which the article is to be treated;
   a mechanism (30) to convey said article to the interior of the tanks in succession, the mechanism including a cantilever arm (34), having at its distal end means to hold said article and whose proximal end is operatively connected to advance means to advance the mechanism with respect to the tanks, said advance means being distant from the tanks, thereby to preclude contaminating particles from the advance means coming into contact with said article; and
   an electronic control means to control said mechanism in accordance with a pre-determined programme.

2. A chemical process apparatus for processing components in a clean room environment comprising:
   a. multiple chemical process tanks (14) for processing electrical components, having front sides (40) and rear sides;
   b. a control means (10) for timing all operations in the apparatus; and
   c. a robot (30) electrically connected to said control means for moving product through successive process tanks, the robot including a horizontal cantilevered arm (34) extending from the rear side of the tanks out over the process tanks (14).

3. Apparatus according to Claim 2, which includes means mounted behind said apparatus for horizontally moving the robot behind the rear sides of the tanks.

4. Apparatus according to Claim 3, wherein the means for moving the robot comprises:
   rails (84) mounted parallel to the rear sides of the tanks, guides (88) on the robot mounted for horizontal slidable movement along the rails and a gear 92, 94 for driving the robot along the rails.

5. Apparatus according to Claim 4, wherein the gear (92, 94) includes a pinion (92) on the robot and a longitudinal rack (94) mounted adjacent the rails.

6. Apparatus according to Claim 5, wherein the rack comprises a row of cylindrical bars for engaging teeth of the pinion.

7. An assembly which comprises:
   (a) apparatus as claimed in any of the preceding claims; and
   (b) a wall, screen, window or other partition to separate from each other a clean zone portion of the apparatus from a chase zone portion of the apparatus.

8. An assembly according to Claim 7, wherein the tanks and at least the distal end of the cantilever arm are disposed in said clean zone and the advance means is disposed in said chase zone area.

9. A robot (30) for moving product through successive processing baths, comprising:
   a. a vertical height-adjustable robot standard (32);
   b. a horizontal arm (34) extending outward from generally the top of the robot standard;
   c. a vertically descending robot arm (36) for engaging product to be processed; and
   d. robot control means including means for moving the robot horizontally behind successive process tanks.

10. A robot (30) for moving product through successive process baths, comprising:
   a. a vertical height-adjustable robot standard (32);
   b. an outwardly extending arm (34) extending from an upper portion of the robot standard;
   c. a downwardly depending robot arm (36) extending from the arm (34) for engaging product to be processed; and
   d. robot control means including means for moving the robot along a pre-determined path.

11. A robot according to Claim 9 or 10, including a computer control (10), for storing an algorithm of movement of product between successive tanks (14) and for storing a time for which the product is resident in each tank, wherein the robot control is in electrical communication with the computer control for receiving robot signals for extending the arm (36) downward to engage product, move product to a selected tank, lower product into a selected tank for a desired residence time, raising upward to remove the product from the tank, and moving horizontally to successive algorithm steps.

12. A robot according to Claim 11 wherein the computer control stores information for a plurality of products so that the robot is signalled to move each of the products to the appropriate tanks at a time specified in the algorithm, the computer control including means for ensuring that algorithms for specific products do not conflict and ensuring that each product has an open path through the system.

FIG. 1

**FIGURE 2**

**FIGURE 3**

FIGURE 4